(19) **Europäisches Patentamt**

**European Patent Office**

**Office européen des brevets**

(11) **EP 1 420 876 B1**

(12) **FASCICULE DE BREVET EUROPEEN**

(45) Date de publication et mention de la délivrance du brevet:
**10.08.2005  Bulletin 2005/32**

(51) Int Cl.$^7$: **B01J 2/00**, H01J 37/32

(21) Numéro de dépôt: **02762661.3**

(86) Numéro de dépôt international:
**PCT/IB2002/003551**

(22) Date de dépôt: **02.09.2002**

(87) Numéro de publication internationale:
**WO 2003/018185 (06.03.2003 Gazette 2003/10)**

(54) **PROCEDE DE FABRICATION DE POUDRE DE GRAINS COMPOSITES ET DISPOSITIF POUR LA MISE EN OEUVRE DU PROCEDE**

VERFAHREN UND VORRICHTUNG ZUR HERSTELLUNG VON PULVER AUS VERBUNDMATERIAL

METHOD OF PRODUCING POWDER WITH COMPOSITE GRAINS AND THE DEVICE FOR CARRYING OUT SAID METHOD

(84) Etats contractants désignés:
**AT BE BG CH CY CZ DE DK EE ES FI FR GB GR IE IT LI LU MC NL PT SE SK TR**

(30) Priorité: **31.08.2001  EP 01120974**

(43) Date de publication de la demande:
**26.05.2004   Bulletin 2004/22**

(73) Titulaire: **Apit Corp. SA**
**1950 Sion (CH)**

(72) Inventeurs:
• **KOULIK, Pavel**
  **F-67113 Blaesheim (FR)**
• **PETROV, Evguenii**
  **F-67400 Illkirch-Graffenstaden (FR)**

• **IVANOV, Mark**
  **F-67400 Illkirch-Graffenstaden (FR)**

(74) Mandataire: **Reuteler, Raymond Werner**
**WILLIAM BLANC & CIE,**
**Conseils en Propriété Industrielle SA,**
**25, Avenue du Pailly**
**1220 Les Avanchets/Genève (CH)**

(56) Documents cités:
WO-A-01/03163          DE-A- 10 003 982
US-A- 3 247 014         US-A- 4 612 432
US-A- 4 859 493         US-A- 5 569 502
US-A- 6 015 597         US-A- 6 113 700
US-A- 6 156 114

Printed by Jouve, 75001 PARIS (FR)

## Description

La présente invention concerne un procédé de fabrication de poudre formée de grains composites et un dispositif pour la mise en oeuvre du procédé.

Dans le domaine des poudres, on connaît plusieurs méthodes de fabrication de poudres, parmi lesquelles des méthodes de fabrication de poudre par plasma.

Dans certaines méthodes, le plasma est utilisé principalement en tant que source de chaleur pour vaporiser ou fondre un aggloméré ou matériau solide, afin de former des particules nanométriques ou submicroniques lors de la condensation et du refroidissement des particules en aval de la source de plasma. Ces méthodes ne permettent toutefois pas de former des grains composites comprenant un noyau et des couches superficielles très minces et uniformes d'un autre matériau.

Outre les méthodes se basant principalement sur l'effet thermique du plasma, on connaît également des procédés de traitement de surface des grains de poudre dans lesquels le plasma est utilisé pour activer la surface des grains afin de changer la propriété de ces grains, tels que décrits par exemple dans les publications DE 196 122 70, DE 195 021 87, EP 654 444, WO 9118124, et US 5,278,384. Dans ces deux dernières publications, on divulgue notamment la formation de poudre composite formée de noyaux entourés d'une couche superficielle d'un autre matériau déposée par activation de la surface du noyau par un plasma à basse température.

Un grand désavantage de ces procédés est que le traitement par plasma est effectué à basse pression, c'est-à-dire sous vide partiel, augmentant ainsi la complexité, le temps et le coût de fabrication industrielle de poudre. A cet égard, il est à remarquer que la basse pression réduit la vitesse de traitement par plasma et donc la productivité du procédé. Par contre, l'utilisation d'un plasma à basse pression facilite l'activation de la surface des matériaux, les réactions plasmochimiques et permet d'obtenir facilement un traitement uniforme sur un large volume.

Le document DE-A-10003982 décrit un procédé et un dispositif de préparation de grains composites dans un réacteur de plasma thermique.

Un but de l'invention est de fournir un procédé de fabrication de poudre formée de grains composites et un dispositif pour la mise en oeuvre du procédé, économes, performants et fiables en milieu industriel.

Il est avantageux de fournir un procédé de fabrication de poudre formée de grains composites comprenant un noyau et une ou plusieurs couches superficielles entourant le noyau, et un dispositif pour la mise en oeuvre d'un procédé, permettant de maîtriser l'uniformité ou l'épaisseur de la couche superficielle entourant le noyau en un autre matériau.

Il est avantageux de fournir un procédé de fabrication de poudre formée de grains composites et un dispositif pour la mise en oeuvre d'un procédé permettant de fabriquer des grains ayant une taille submicronique ou nanométrique. Il est également avantageux de pouvoir fabriquer des grains ayant un noyau et plusieurs couches superficielles minces de matériaux ou de molécules ou d'atomes différents.

Il est avantageux de fabriquer de la poudre de grains composites formés d'un noyau et d'une ou plusieurs couches superficielles entourant le noyau, cette poudre acquérant des propriétés physico-chimiques différentes des propriétés du noyau.

Des buts de l'invention sont réalisés par un procédé de fabrication de poudre de grains composites selon la revendication 1, un dispositif pour la mise en oeuvre du procédé selon la revendication 11, et un filtre hydrodynamique pour un réacteur de plasma selon la revendication 22.

Dans la présente invention, un procédé de fabrication de poudre formée de grains composites comprenant un noyau et une ou plusieurs couches superficielles, comporte les étapes: de mélanger des noyaux de grains avec un gaz de traitement plasmochimique, de passer le mélange de noyaux et de gaz de traitement plasmochimique à travers un réacteur de plasma, et de génération d'un plasma essentiellement à pression atmosphérique dans le réacteur afin de créer une réaction plasmochimique entre le gaz de traitement et les surfaces des noyaux pour la formation de couches superficielles sur celles-ci pendant que le flux dudit mélange traverse le réacteur.

Avantageusement, les poudres composites sont formées par un dépôt de film en milieu plasma à pression atmosphérique, ce qui permet de réaliser un procédé et dispositif industriel simple, fiable, économe et de haute productivité. Le plasma sert à échauffer et activer la surface des noyaux avant de les mettre en contact avec les atomes et/ou molécules destinés à générer le film périphérique. Les paramètres du plasma assurant le dépôt du film périphérique et du plasma activant les noyaux peuvent être choisis de telle manière que le dépôt s'effectue sous forme de film homogène et très mince.

Dans la présente invention, on peut réaliser des poudres dont les grains sont composés d'un noyau et d'une ou plusieurs zones périphériques résultant du dépôt d'un ou de plusieurs films minces, uniformes et homogènes d'atomes et/ou de molécules (radicaux) pour donner à la poudre résultante des propriétés différentes des propriétés d'une poudre constituée des noyaux seuls.

Selon un aspect avantageux de l'invention, avant le passage des noyaux et de gaz de traitement à travers la zone de traitement par plasma, on les fait passer à travers un filtre hydrodynamique dans la forme, par exemple, d'un filtre à multiples canaux longitudinaux (du type nid d'abeilles), ayant comme effet d'uniformiser la vitesse et la direction du flux des noyaux et de gaz à travers le réacteur de plasma. Ceci permet d'uniformiser et mieux maîtriser les paramètres influençant le traitement, tels que le temps de passage des noyaux à travers le réacteur, la température, la pression et la vitesse relative des noyaux dans le gaz. On améliore ainsi l'uniformité de traitement des noyaux, et notamment l'uniformité et l'homogénéité de l'épaisseur des couches superficielles formées sur les noyaux. Cette mesure permet aussi de minimiser la dispersion des dimensions et des propriétés des poudres obtenues.

Selon un aspect avantageux de l'invention, pour intensifier le procédé, l'on génère une vibration acoustique, en particulier ultrasonique, dans le plasma. Les vibrations se transfèrent aux noyaux par l'intermédiaire du gaz. Les vibrations peuvent être générées par un générateur de vibrations acoustiques externe, ou par un processus spécial de génération du plasma selon un aspect avantageux de l'invention. A cet effet, on peut générer le plasma par impulsions, la durée du front de croissance de la tension, la durée des impulsions, et leur fréquence étant choisies de manière à générer régulièrement des ondes de choc dans le plasma. Ces ondes de choc, interférant d'une part avec les parois du réacteur, et, d'autre part avec les particules du plasma, engendrent des oscillations, notamment ultrasoniques, intensifiant fortement le procédé de dépôt de film.

Il est avantageux d'injecter, le long de la surface interne de la paroi du réacteur, un gaz neutre de densité proche de celle des gaz du mélange afin de limiter les effets néfastes de la couche limite. En effet, les gaz et particules dans la couche limite, vu leurs vitesses de transport substantiellement différentes de celles des particules centrales, sont exposés à un traitement différent de celui des particules centrales (ce qui donne une poudre non homogène et non uniforme). La présence de gaz a pour effet d'une part de refroidir et d'isoler la paroi du réacteur du plasma chaud, d'autre part d'éloigner les noyaux et gaz réactifs de la couche limite.

L'homogénéité des grains peut être encore améliorée en fournissant un canal d'échappement en aval de la zone de traitement du réacteur de plasma le long de sa paroi afin d'évacuer les gaz et les grains s'écoulant dans la couche limite des parois. En effet, la vitesse des gaz proches de la paroi, c'est-à-dire dans la couche limite, est plus faible que dans la majeure partie centrale de la colonne de flux traversant le réacteur, de sorte que les paramètres de traitement ne sont pas les mêmes pour les particules dans la couche limite et celles dans la partie centrale. En évacuant les grains et gaz périphériques, on arrive donc à obtenir des poudres ayant des grains d'une grande homogénéité.

Afin de former des couches superficielles de différentes molécules ou d'atomes, on peut prévoir plusieurs dispositifs de traitement les uns sur les autres, ou de réaliser un dispositif avec plusieurs réacteurs plasma les uns sur les autres, séparés par des chambres permettant le mélange de gaz de traitement avec les noyaux introduits dans le dispositif, respectivement sortant de l'étage précédent de traitement par plasma.

D'autres buts et caractéristiques avantageux de l'invention ressortiront des revendications, de la description des formes d'exécution de l'invention ci-après et des dessins annexés, dans lesquels:

la Fig. 1 est une vue en coupe, schématique, d'un dispositif de fabrication de poudre composite par plasma selon l'invention;

la Fig. 1a illustre des graphiques des profiles de vitesse du flux de gaz et/ou de noyaux avant et après un filtre hydrodynamique du dispositif disposé avant une zone de traitement par plasma;

la Fig. 1b est une vue partielle en coupe de la paroi du réacteur de plasma du dispositif de la Fig. 1;

la Fig. 2 est une vue en coupe, schématique, d'un dispositif de fabrication de poudre composite par plasma selon une deuxième forme d'exécution de l'invention;

la Fig. 3 est une vue en coupe, schématique, d'un dispositif de fabrication de poudre composite par plasma selon une troisième forme d'exécution de l'invention.

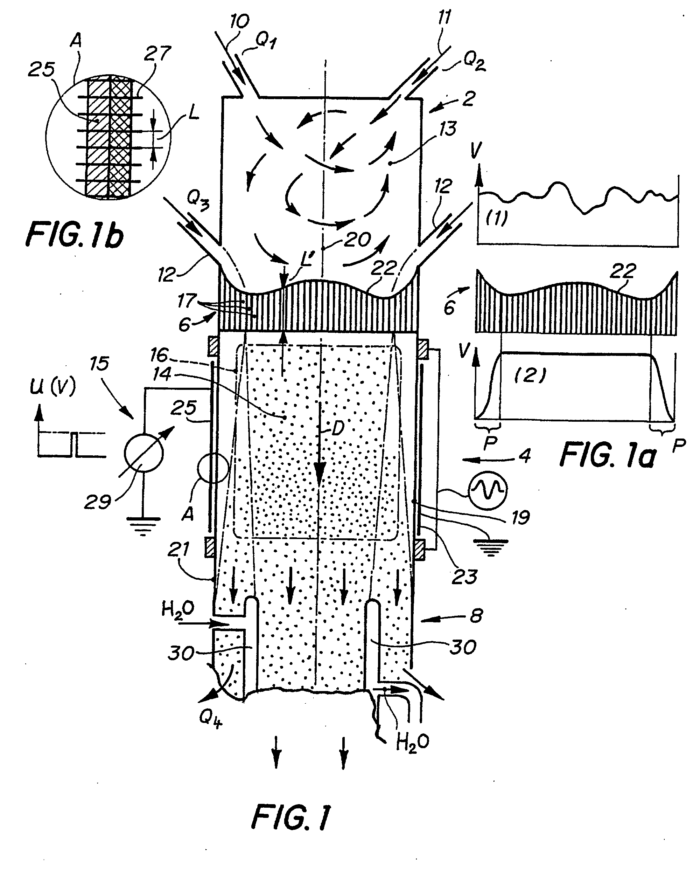

Faisant référence à la figure 1, un dispositif pour la fabrication de poudre composite par plasma selon une première forme d'exécution comprend une partie mélangeur 2, un réacteur de plasma 4, un filtre hydrodynamique 6 disposé entre la partie mélangeur et le réacteur et une partie collecteur 8 à la sortie du réacteur. La partie mélangeur est disposée en amont du réacteur, par rapport à la direction D du flux de gaz et de particules dans le dispositif, et comprend des entrées 10, 11 d'introduction de gaz et de noyaux, une entrée 10 étant pour l'introduction de noyaux avec un gaz porteur Q1 et l'autre entrée 11 étant pour l'introduction de gaz de traitement Q2 pour le dépôt de couches superficielles de molécules ou d'atomes sur les noyaux. Les entrées peuvent être conçues sous forme de jets dirigés vers le centre de la chambre 13 du mélangeur afin qu'il y ait une turbulisation et un mélange du gaz porteurs des noyaux et du gaz de traitement. La partie mélangeur peut également comporter des entrées latérales 12 de gaz neutres Q3 destinés à s'écouler le long de la surface interne de la paroi du dispositif. Le gaz neutre est avantageusement inerte et a, de préférence, une densité proche du mélange des gaz porteur et de traitement.

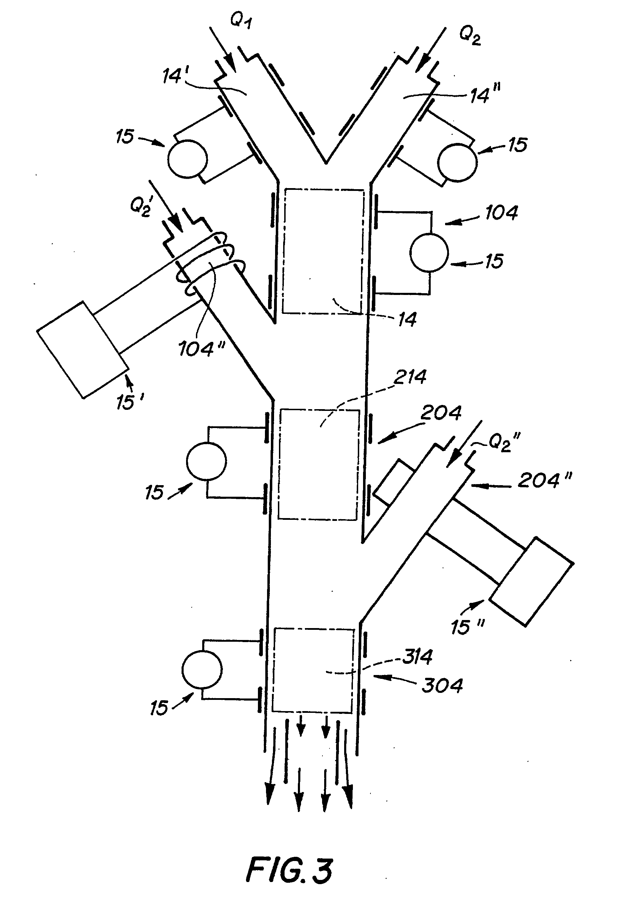

Le réacteur 4 comprend un dispositif de génération de plasma 15 destiné à générer un plasma dans la chambre 14 du réacteur, définissant une zone de traitement indiquée par la ligne pointillée 16. Le générateur de plasma peut avoir différentes constructions, dépendant s'il s'agit d'un générateur de plasma par effet capacitif 15, d'un générateur de plasma haute fréquence (HF) par induction 15', ou d'un générateur de plasma par micro-ondes 15" (voir Fig. 3).

Chacun de ces générateurs peut fonctionner soit en régime continu soit en régime par impulsions. Une des méthodes de génération préférées du plasma est par impulsions dont les caractéristiques permettent de générer des plasmas produisant des ondes de choc interférentes. En particulier, la durée du front de croissance de la tension, la durée des impulsions, et leur fréquence sont choisies de manière à générer régulièrement des ondes de choc dans le plasma. Ces ondes de choc, interférant d'une part avec les parois du réacteur, et, d'autre part entre elles et avec les particules du plasma, engendrent des oscillations, notamment ultrasoniques, du milieu, intensifiant fortement le procédé de dépôt de film. Le procédé de génération d'un plasma atmosphérique en impulsions permet de créer un plasma uniforme dans un volume donné.

Le réacteur de plasma 4 peut avoir une forme essentiellement parallélépipédique, deux faces opposées 19, 21 étant recouvertes par des électrodes 23, 25. Une des électrodes 23, comporte des aiguilles métalliques 27 et est reliée à une source de courant 29 à haute fréquence, par impulsion. L'autre électrode 23 est plane et reliée à la terre.

Sur la Fig. 1 est représenté un générateur de plasma de configuration parallélépipédique (géométrie planaire).

Il est aussi avantageux de réaliser le générateur de plasma dans une géométrie coaxiale. Dans ce cas, les électrodes ont la forme de deux cylindres coaxiaux entre lesquels, parallèlement à l'axe, passe le mélange gazeux et, radialement, sont générées les décharges en filaments qui créent le milieu du plasma activant. Pour des raisons de sécurité, il est avantageux de connecter l'électrode centrale sur laquelle, dans ce cas, sont implantées les aiguilles métalliques, à la source de courant à haute fréquence, l'autre électrode étant connectée à la terre.

En état de marche, la décharge électrique issue des aiguilles 27 a d'abord la forme de canaux cylindriques de diamètre d (d - 0,5mm) de forme irrégulière, reliant l'électrode sous tension 25 à l'électrode à la terre 23. La durée $t_1$ du front de l'impulsion du courant est choisie de telle manière que l'échauffement du canal soit isochorique, c.à.d. que $t_1 \leq d/a$ où a est la vitesse du son dans le milieu.

La pression augmente dans le canal, atteint et dépasse la valeur critique de formation d'une onde de choc qui se propage en direction radiale.

L'onde de choc qui se propage ionise le milieu. Le canal s'élargit rapidement, le plasma étant alimenté par le courant croissant qui le traverse.

L'impulsion a une durée $t_2$ choisie de manière à assurer le passage du courant à travers toute la section du conduit: $t_2 \sim L/a$, ou L est la distance entre les aiguilles de l'électrode sous tension. Le passage du courant est alors interrompu pendant un laps de temps $t_3$ inférieur ou égal au temps de relaxation (de déionisation) du milieu gazeux dans lequel a lieu la décharge. Cette interruption ne permet pas à la décharge de se contracter et de se localiser. Le temps de relaxation du système dépend des propriétés du milieux gazeux dans lequel a lieu la décharge et de ses paramètres hydrodynamiques. Il est choisi et optimisé de manière empirique. Pendant le fonctionnement du générateur de plasma, l'excitation du milieu s'avère homogène dans tout le volume du plasma, l'uniformité étant due, en particulier, à l'interférence des ondes de choc issues des différents canaux.

A titre d'exemple, dans le cas concret du passage d'un mélange composé d'argon (80%) de vapeurs de HDMS (15%) et de noyaux de fer (5%), le générateur de plasma a fonctionné correctement à des valeurs:

$t_1 = 3.10^{-7}$ sec
$t_2 = 10^{-5}$ sec (L = $5.10^{-3}$ m)
$t_3 = 10^{-4}$ sec

La fréquence du générateur était de 13,56 MHz.

Le filtre hydrodynamique 6 disposé entre le mélangeur et le réacteur de plasma est destiné à uniformiser et stabiliser le flux du mélange gazeux de façon à lui donner un profil de vitesse *V* relativement constant à travers la colonne du flux de gaz, comme illustré dans la Fig. 1a. On constate à la Fig. 1a que la vitesse *V*(1) longitudinale du mélange gazeux dans la partie mélangeur est non constante, l'épure étant chaotique, alors qu'après le passage du filtre hydrodynamique 6, la vitesse longitudinale *V*(2) du mélange gazeux est pratiquement uniforme, sauf à la périphérie *P* qui est occupée par le gaz neutre Q3 introduit par les entrées latérales 12. Le gaz neutre forme principalement la couche limite sur la surface interne de la paroi du réacteur, ayant pour effet d'une part de refroidir et d'isoler la paroi du réacteur du plasma chaud, d'autre part d'éloigner les noyaux de la couche limite. Le gaz dans la couche limite est séparé du flux principal et évacué à la sortie du réacteur comme décrit plus loin.

Le filtre hydrodynamique comprend, de préférence, des petits canaux longitudinaux 17 alignés avec la direction *D* du flux du mélange gazeux à travers le réacteur, les canaux ayant des longueurs qui peuvent varier en fonction de la distance les séparant du centre 20 de l'enceinte. Comme la longueur *L'* des canaux influence la résistance sur le flux gazeux traversant le filtre, la variation de longueur des canaux peut être empiriquement déterminée en fonction de la géométrie et largeur des chambres 13,14 et le débit du flux. Comme la vitesse au centre de la colonne du mélange gazeux serait normalement plus élevée qu'à la périphérie, le profil 22 du filtre hydrodynamique 6 a de préférence une forme convexe, telle que montrée dans la Fig. 1 et la Fig. 1a. Le filtre hydrodynamique peut avoir une construction ressemblent à un « nid d'abeilles » (honey comb).

A la sortie du réacteur (partie collecteur 8), le dispositif comprend un canal périphérique d'évacuation 28 disposé de manière à ne récolter que les gaz et particules Q4 à la périphérie du flux. Ceci permet d'écarter les noyaux et grains de poudre qui se sont écoulés le long de la paroi dans la couche limite, et qui ont subi un traitement différent des grains dans la partie majeure centrale du flux en raison de la vitesse d'écoulement non uniforme dans la couche limite, et de la présence du gaz neutre Q3.

La partie collecteur 8 peut être munie d'un circuit de refroidissement 30 afin de la protéger d'une destruction thermique et de refroidir le mélange gazeux et les grains de poudre sortant du réacteur et récoltés par un filtre ou autre séparateur (non montré) connu des systèmes conventionnels de fabrication de poudres.

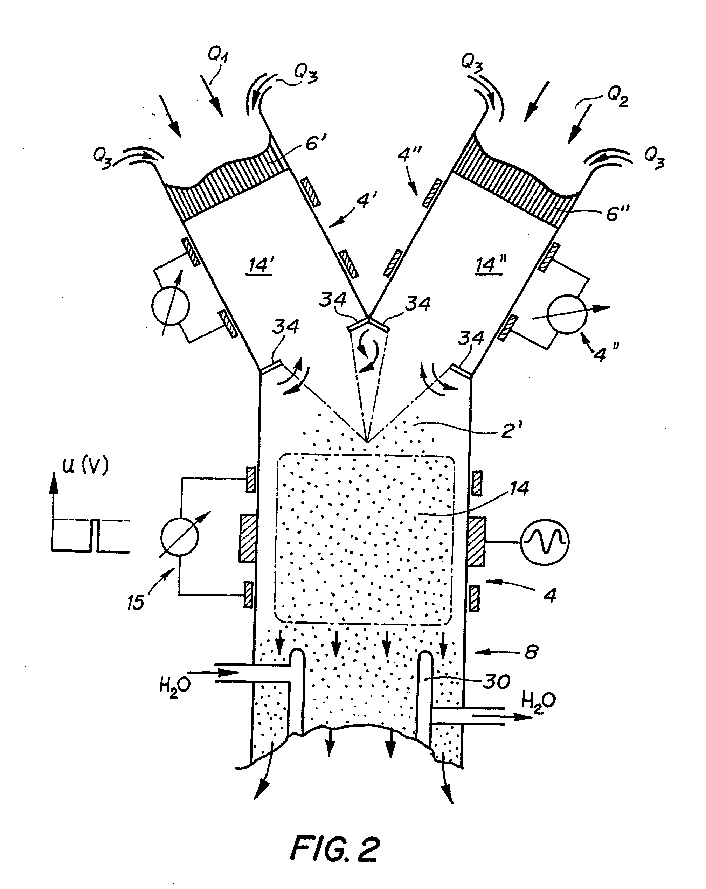

La figure 2 illustre une deuxième forme d'exécution d'un dispositif de fabrication de poudre de grains composites selon l'invention. Dans ce cas, le dispositif comprend des réacteurs de plasma de prétraitement séparés 4', 4" dans lesquels le gaz porteur portant les noyaux Q1, respectivement le gaz de traitement Q2, sont introduits. On peut également injecter un gaz neutre Q3 le long des parois de chaque réacteur de prétraitement pour former la couche limite comme décrit auparavant en relation avec la forme d'exécution de la figure 1.

Chaque réacteur de prétraitement 4', 4" est pourvu d'un filtre hydrodynamique 6 à son entrée pour uniformiser l'épure des vitesses longitudinales des gaz introduites dans ces réacteurs. La sortie des réacteurs de prétraitement communique avec un réacteur principal de plasma commun où le gaz porteur portant les noyaux et le gaz de traitement sont mélangés. Des éléments ou lames de turbulisation 34 avantageusement refroidis, disposés à la sortie des réacteurs de prétraitement, créent une turbulisation des flux respectifs pour assurer un bon mélange des gaz de traitement et des noyaux dans une partie de chambre mélangeur à l'entrée du réacteur principal de plasma 4, et par la suite dans le zone de traitement 14 du réacteur principal.

La longueur du trajet des flux entre les réacteurs de plasma de prétraitement 4', 4" et le réacteur principal 4 est telle que les noyaux et gaz activés dans les zones de prétraitement 14' et 14" ne se désactivent pas (c'est-à-dire que le temps de transport est inférieur au temps de relaxation).

Dans la deuxième forme d'exécution, les flux de gaz de traitement Q2 et de gaz porteur portant la poudre de noyaux Q1 sont donc introduits dans des réacteurs de plasma de prétraitement 4', 4" séparés. Par l'intermédiaire des filtres hydrodynamiques 6 et de flux de gaz neutres Q3 injectés en périphérie, ils sont homogénéisés et ensuite pénètrent dans des zones de plasma 14', 14" où ils sont activés. Les deux flux alors se rejoignent. Pour en assurer le bon mélange ils sont turbulisés par des dispositifs 34 qui perturbent le flux. Le mélange activé pénètre dans une deuxième zone de plasma 14 où une nouvelle activation s'opère, qui catalyse le processus de dépôt de film sur les noyaux. Dans ce procédé, il est important que le temps entre le prétraitement et la mise en contact des particules de gaz de traitement avec les noyaux soit inférieur au temps de relaxation de l'excitation des composantes activés par le plasma de prétraitement. L'évacuation des gaz et grains de la couche limite ainsi que la récolte de la poudre de grains composites s'effectuent comme dans la forme d'exécution précédente.

La figure 3 illustre un autre forme d'exécution de la présente invention. Dans ce cas, il est question de créer une superposition de films de différentes compositions et propriétés physico-chimiques sur un même noyau. Ce procédé s'effectue dans un dispositif qui comprend plusieurs étages de réacteurs de plasma 104, 204, 304.

Le premier étage 104 du dispositif de la figure 3 reprend essentiellement les caractéristiques du dispositif montré dans la figure 2. En aval du premier étage 104, on injecte dans le flux contenant des grains recouvertes d'une première couche un gaz de traitement Q2' d'une nouvelle composition chimique, ce qui, dans la zone de traitement de plasma 214 du deuxième étage 204 permet de déposer une nouvelle couche sur les grains. Le nouveau gaz de traitement Q2' peut subir un prétraitement (activation) par plasma en traversant un réacteur de plasma de prétraitement 104" du dispositif, disposé à la sortie du premier étage. D'une manière similaire on dépose une troisième couche dans la zone de traitement 314 du troisième étage 304 avec l'injection d'un gaz de traitement Q2" d'une nouvelle composition en amont de la troisième réacteur. Comme dans l'étage précédent, le nouveau gaz de traitement Q2" peut subir une prétraitement (activation) par plasma en traversant un réacteur de plasma de prétraitement 204" du dispositif, disposé à la sortie du deuxième étage. Le dispositif peut avoir des étages supplémentaires pour que le procédé puisse être répété consécutivement autant de fois qu'il y a besoin de couches sur le noyau initial.

Dans les procédés selon l'invention décrits ci-dessus, les composantes du plasma générant le film sont choisies de manière que les forces d'attraction entre les particules du film aient une composante centripète concourant à solidifier la structure de l'enveloppe de film périphérique. Cette composante est d'autant plus grande que la dimension des noyaux est petite. Elle est surtout importante dans le cas de poudres de noyaux submicroniques et nanométriques. Dans ces derniers cas, pour bien séparer les grains-noyaux flottant dans un gaz d'apport (par exemple de l'argon) et d'autre part pour leur communiquer un mouvement artificiel de vibrations, catalysant le processus de dépôt, on peut les soumettre à l'action de vibrations acoustiques, en particulier ultrasoniques. Ces vibrations peuvent être générées par un générateur extérieur, ou par le plasma lui-même, dans un mode de génération du plasma par impulsions comme décrit plus loin

Pour que le dépôt de film soit efficace, il est important d'activer (d'exciter) le gaz de traitement contenant les composantes chimiques (par exemple mélange de vapeurs d'hexaméthyldisilasane et d'oxygène). Les électrons du plasma échauffent le gaz de traitement, et d'autre part excitent les atomes et molécules, ce qui les décomposent pour former des radicaux. A l'état excité ces particules activées sont très aptes à former, sur une surface solide, par exemple la surface des noyaux, un film dont les propriétés physico-chimiques telles que les propriétés optiques sont différentes des propriétés des noyaux.

Vu que le procédé de dépôt de film est un procédé qui se sature, c.à.d que la vitesse de dépôt décroît exponentiellement avec l'épaisseur, il est utile dans certains cas de surcharger le gaz de traitement de ses composantes chimiques.

Dans ce cas, une uniformisation et une homogénéisation automatique des grains composites de poudre aura lieu. On peut donc avantageusement régler le débit des gaz de traitement de manière à fonctionner en régime de saturation. Dans ce cas l'épaisseur de la couche saturée déposée sur les noyaux est contrôlée par le temps de présence des noyaux dans la zone de traitement par plasma avec le gaz de traitement activé

Pour améliorer ce procédé on peut soumettre les noyaux initiaux à une excitation préalable, soit par exemple en les échauffant soit en les irradiant, ou en les soumettant à l'action d'un plasma. Dans ce cas les électrons du plasma viendront activer les liaisons superficielles des atomes de la surface. Ceux-ci resteront excités pendant un temps de relaxation durant lequel, pour que la formation dudit film ait lieu, ces noyaux doivent rencontrer les particules (activées) du gaz de traitement.

Il est avantageux, pour que le procédé soit efficace, que l'énergie dépensée pour l'excitation notamment thermique des atomes ou molécules du gaz soit supérieure à leurs énergies respectives d'excitation. Les expériences faites dans le cadre de cette invention montre que cette énergie en pratique doit être supérieure à 0,02eV/atome ou molécule. Cette valeur limite d'énergie dépensée est empirique et peut être estimée expérimentalement de la manière suivante, dans le cas de l'excitation par plasma :

- on mesure la puissance incidente $P_1$ de la source de courant,
- on mesure par calorimétrie la puissance perdue par refroidissement $P_2$,
- éventuellement on mesure par radiométrie la puissance irradiée $P_3$,
- on mesure le débit G de gaz traité par le plasma

Le rapport : $(P_1 - P_2 - P_3)\alpha / G$ où $\alpha$ est le coefficient d'accomodation $\sim 10^{-2}$ donne la valeur recherchée.

D'autre part l'énergie dépensée ne doit pas être supérieure à l'énergie de destruction des noyaux (par exemple par ablation). Cela signifie que l'énergie dépensée par particule répond à la condition :

$$E_{dép} \leq (C.\ \Delta T_{destr}.d.G) / (n_{gaz}, v_{term}.L.S.\alpha)$$

où :

C est la capacité thermique du matériau du noyau,
$\Delta T_{destr}$ est la température de destruction de ce matériau (par exemple la température de sublimation),
d est le diamètre effectif du noyau,
G est le débit de gaz emportant les composantes à travers le plasma,
n est la densité de ce gaz,
$v_{term}$ est la vitesse thermique des particules de ce gaz,
L est la longueur du réacteur,
S est la section du réacteur,
$\alpha$ est le coefficient d'accommodation.

Le procédé selon l'invention est avantageux pour obtenir des propriétés physico-chimiques spéciales, par exemple des effets optiques sur les poudres qui sont à l'origine de fabrication de couleurs et de vernis.

## Exemple 1

| Dispositif selon la figure 1 | |
|---|---|
| Poudre de noyaux | Fe |
| Gaz d'apport des noyaux | argon |
| Gaz de traitement d'hexaméthyldisilazane | argon+$O_2$+vapeurs |
| Plasma | haute fréquence,13,56MHz,puissance 35kW |
| Diamètre effectif des noyaux | d=700nm |
| Débit de gaz à la sortie du réacteur | G=10 l/sec |
| Section du réacteur de plasma | S=6cm$^2$ |
| Résultat | formation d'un film SiO$_2$ d'une épaisseur de ~100nm à la périphérie des grains de Fe. |

Exemple 2

| Dispositif selon la figure 3 | |
|---|---|
| Poudre de noyaux | Fe |
| Gaz d'apport | argon |
| Gaz de traitements | |
| 1$^{er}$ réacteur | Ar+$O_2$+vapeurs d'hexaméthyldisilazane |
| 2$^{ème}$ réacteur | Ar+$O_2$+vapeurs de tétrachlorure de titane |
| Plasma | |
| 1$^{er}$ réacteur | haute fréquence, 13,56MHz, puissance 30kW |
| 2$^{ème}$ réacteur | haute fréquence, 13,56MHz, puissance 20kW |
| 3$^{ème}$ réacteur | non fonctionnant |
| Diamètre effectif des noyaux | 0,7µm |
| Débit de gaz à la sortie | 10 l/sec |
| Section des réacteurs | 6cm$^2$ |
| Résultat | Formation à la périphérie des grains de Fe d'un film double composé de : 1) une couche de SiO$_2$, épaisseur ~ 100nm, et 2) une couche de TiO$_2$, épaisseur ~ 50nm |

## Revendications

1. Un procédé de fabrication de poudre formée de grains composites comprenant un noyau et une ou plusieurs couches superficielles, comporte les étapes: de mélange des noyaux de grains avec un gaz de traitement plasmochimique, de passage à travers un réacteur de plasma principal d'un flux dudit mélange de noyaux et de gaz de traitement, et de génération d'un plasma essentiellement à pression atmosphérique uniforme dans une zone de traitement du réacteur principal afin de créer une réaction plasmochimique entre le gaz de traitement et les surfaces des noyaux pour la formation de couches superficielles sur celles-ci pendant que le flux dudit mélange traverse le réacteur.

2. Procédé de fabrication de poudre selon la revendication 1 **caractérisé en ce que** la surface des noyaux est préalablement activée en amont de la zone de traitement par plasma du réacteur principal.

3. Procédé de fabrication de poudre, selon la revendication 1 ou 2, **caractérisé en ce que** l'énergie d'excitation des atomes ou molécules du gaz de traitement générant la couche déposée sur le noyau est comprise entre 0,02eV par atome ou molécule et l'énergie de décomposition thermique du noyau.

4. Procédé selon l'une des revendications précédentes, **caractérisé en ce que** le plasma est généré en impulsions dont le front, la durée et la fréquence sont tels qu'elles génèrent des ondes de choc générant des vibrations acoustiques.

5. Procédé selon l'une des revendications précédentes, **caractérisé en ce qu'**on génère des vibrations acoustiques dans le plasma au moyen d'un générateur acoustique externe.

6. Procédé selon l'une des revendications précédentes, **caractérisé en ce que** les gaz de traitement et le gaz porteur contenant les noyaux sont mélangés de manière homogène en amont de la zone de traitement par plasma.

7. Procédé selon la revendication précédente **caractérisé en ce que** le flux de mélange gazeux est uniformisé avant son excitation par plasma, au moyen d'un filtre hydrodynamique.

8. Procédé selon l'une des revendications précédentes, **caractérisé en ce que** l'on injecte un gaz neutre le long des parois du ou des réacteurs de plasma pour former la couche limite de gaz sur la surface interne desdites parois.

9. Procédé selon l'une des revendications précédentes **caractérisé en ce que** les flux de gaz de traitement et le flux de gaz porteur portant les noyaux sont excités séparément et mis en contact après leur excitation, le temps entre l'excitation et la mise en contact étant inférieur au temps de relaxation de l'excitation des composantes des gaz et des noyaux.

10. Procédé selon l'une des revendications précédentes, **caractérisé en ce que** te débit de gaz de traitement est choisi de manière à atteindre une saturation du processus de dépôt de la couche superficielle, sur les noyaux, l'épaisseur de la couche déposée étant contrôlée par le temps de présence des noyaux dans la zone de traitement par plasma avec les gaz de traitement.

11. Dispositif pour la mise en oeuvre d'un procédé de fabrication de poudre formée de grains composites comprenant un noyau et une ou plusieurs couches superficielles selon l'une des revendications 1 à 10, comportant un réacteur de plasma principal (4, 10, 204, 304) fonctionnant à pression atmosphérique, le réacteur comprenant un dispositif de génération de plasma (15) et une chambre (14) définissant une zone de traitement de plasma à travers laquelle un flux de mélange de gaz de traitement plasmochimique et des noyaux s'écoule, et une partie mélangeur (2,2') en amont de la zone de traitement pour mélanger les gaz de traitement et les noyaux portés par un gaz porteur, **caractérisé en ce qu'**il comprend au moins un filtre hydrodynamique (6, 6', 6") en amont de la zone de traitement par plasma pour uniformiser la vitesse du mélange de gaz et noyaux traversant le filtre hydrodynamique.

12. Dispositif selon la revendication précédente, **caractérisé en ce que** le filtre hydrodynamique est disposé entre la partie mélangeur (2) et la zone de traitement par plasma (14).

13. Dispositif selon l'une des revendications 11 à 12, **caractérisé en ce qu'**il comporte des réacteurs de plasma de prétraitement (4', 4") en amont du réacteur de plasma principal permettant d'activer séparément le flux de gaz de traitement et les noyaux portés par un gaz porteur.

14. Dispositif selon la revendication précédente **caractérisé en ce que** chaque réacteur de plasma de prétraitement est muni d'un desdites filtres hydrodynamiques en amont de sa zone de traitement par plasma (14', 14") respective.

15. Dispositif selon l'une des revendications 11 à 14 **caractérisé en ce qu'**il comprend une ou plusieurs sources extérieures de vibrations acoustiques.

16. Dispositif selon l'une des revendications 11 à 15, **caractérisé en ce que** le dispositif de génération de plasma comprend des moyens de génération du plasma par impulsions.

17. Dispositif selon l'une des revendications 11 à 16, **caractérisé en ce qu'**il comprend des entrées latérales (12) pour l'injection d'un gaz neutre le long de la surface interne de la paroi du ou des réacteurs de plasma (4, 4', 4").

18. Dispositif selon l'une des revendications 11 à 17, **caractérisé en ce qu'**il comprend une partie collecteur (8) à la sortie du dispositif comprenant un canal périphérique d'évacuation des gaz et des noyaux s'écoulant dans la couche limite le long de la surface interne du réacteur.

19. Dispositif selon l'une des revendications 11 à 18 **caractérisé en ce que** le filtre hydrodynamique comprend une pluralité de petits canaux longitudinaux dirigés dans la direction du flux à travers le réacteur qu'il précède.

20. Dispositif selon l'une des revendications 11 à 19 **caractérisé en ce que** le dispositif de génération de plasma comprend des électrodes (23, 25) disposées de part et d'autre de la zone de traitement par plasma (14), l'une des électrodes comportant des aiguilles métalliques (27) distribuées sur la surface de l'électrode et dirigées vers l'autre électrode, et la source de courant HF étant une source à impulsions.

21. Dispositif selon la revendication précédente, **caractérisé en ce que** le réacteur de plasma est parallélépipédique, les électrodes étant disposées sur des faces opposées parallèles à la direction du flux du gaz.

22. Dispositif selon la revendication 20, **caractérisé en ce que** le réacteur de plasma est cylindrique et composé de deux électrodes coaxiales, leurs axes étant parallèles à la direction du flux du gaz.

23. Dispositif selon la revendication précédente, **caractérisé en ce que** l'électrode centrale est connectée à la source de courant HF à impulsions et comprend les aiguilles métalliques, l'électrode périphérique étant à la terre.

24. Dispositif selon la revendication 19, **caractérisé en ce que** la longueur des canaux longitudinaux est supérieure au centre du filtre qu'en s'éloignent du centre.

25. Dispositif selon la revendication 19 ou 24, **caractérisé en ce que** les canaux sont formés par des parois minces d'une structure essentiellement sous forme de nid d'abeille.


**Patentansprüche**

1. Ein Herstellungsverfahren für ein Pulver, das aus Verbundmaterialkörnern gebildet wird, die einen Kern sowie eine oder mehrere oberflächliche Schichten umfassen, weist die Schritte auf: Vermischen der Kerne der Körner mit einem Gas für plasmachemische Behandlung, Durchlaufen eines Plasmahauptreaktors durch einen Strom des Gemischs aus Kernen und Behandlungsgasen und Erzeugung eines Plasmas im Wesentlichen bei gleichförmigem Atmosphärendruck in einer Behandlungszone des Hauptreaktors, um eine plasmachemische Reaktion zwischen dem Behandlungsgas und den Oberflächen der Kerne zu bewirken und oberflächliche Schichten auf diesen Kernen zu bilden, während der Strom des Gemischs den Reaktor durchläuft.

2. Pulverherstellungsverfahren nach Anspruch 1, **dadurch gekennzeichnet, dass** die Oberfläche der Kerne im Voraus stromauf von der Plasmabehandlungszone des Hauptreaktors aktiviert wird.

3. Pulverherstellungsverfahren nach Anspruch 1 oder 2, **dadurch gekennzeichnet, dass** die Anregungsenergie der Atome oder Moleküle des Behandlungsgases, die die auf dem Kern abgeschiedene Schicht erzeugen, zwischen 0,02 eV je Atom oder Molekül und der thermischen Zersetzungsenergie des Kems liegt.

4. Verfahren nach einem der vorangehenden Ansprüche, **dadurch gekennzeichnet, dass** das Plasma durch Impulse erzeugt wird, deren Flanke, Dauer und Frequenz so gewählt sind, dass sie Stosswellen erzeugen, die akustische Vibrationen erzeugen.

5. Verfahren nach einem der vorangehenden Ansprüche, **dadurch gekennzeichnet, dass** vermittels eines externen Schallgenerators im Plasma akustische Vibrationen erzeugt werden.

6. Verfahren nach einem der vorangehenden Ansprüche, **dadurch gekennzeichnet, dass** die Behandlungsgase und das die Kerne enthaltende Trägergas stromauf von der Plasmabehandlungszone homogen vermischt werden.

7. Verfahren nach dem vorangehenden Anspruch, **dadurch gekennzeichnet, dass** der Strom der Gasmischung vor seiner Anregung durch ein Plasma mittels eines hydrodynamischen Filters gleichförmig gemacht wird.

8. Verfahren nach einem der vorangehenden Ansprüche, **dadurch gekennzeichnet, dass** ein neutrales Gas entlang der Wandungen des oder der Plasmareaktoren eingeblasen wird, um die Grenzschicht von Gasen auf der Innenseite dieser Wandungen zu bilden.

9. Verfahren nach einem der vorangehenden Ansprüche, **dadurch gekennzeichnet, dass** die Ströme der Behandlungsgase und der Strom des die Kerne mitführenden Trägergases getrennt angeregt und nach ihrer Anregung in Berührung gebracht werden, wobei die Zeit zwischen der Anregung und der Kontaktierung kürzer als die Relaxationszeit der Anregung der Gaskomponenten und der Kerne ist.

10. Verfahren nach einem der vorangehenden Ansprüche, **dadurch gekennzeichnet, dass** der Durchsatz des Behandlungsgases so gewählt wird, dass eine Sättigung des Abscheidungsprozesses der oberflächlichen Schicht auf den Kernen erreicht wird, wobei die Dicke der abgeschiedenen Schicht durch die Zeit der Anwesenheit der Kerne mit den Behandlungsgasen in der Plasmabehandlungszone gesteuert wird.

11. Vorrichtung zur Ausführung eines Herstellungsverfahrens nach einem der Ansprüche 1 bis 10 für ein Pulver, das aus Verbundmaterialkörnern gebildet wird, die aus einem Kern und einer oder mehreren oberflächlichen Schichten bestehen, einen Plasmahauptreaktor (4, 10, 204, 304) aufweisend, der bei atmosphärischem Druck arbeitet, wobei der Reaktor eine Vorrichtung zur Plasmaerzeugung (15) und eine Kammer (14), die eine Plasmabehandlungszone definiert, die von einem Strom des Gemischs der Gase für die plasmachemische Behandlung und der Kerne durchflossen wird, sowie einen Mischabschnitt (2, 2') stromauf von der Behandlungszone umfasst, um die Behandlungsgase und die durch ein Trägergas mitgeführten Kerne zu vermischen, **dadurch gekennzeichnet, dass** sie zumindest ein hydrodynamisches Filter (6, 6', 6") stromauf von der Plasmabehandlungszone umfasst, um die Geschwindigkeit des Gemischs von Gasen und Kernen, die das hydrodynamische Filter durchlaufen, gleichförmig zu machen.

12. Vorrichtung nach dem vorangehenden Anspruch, **dadurch gekennzeichnet, dass** das hydrodynamische Filter zwischen dem Mischabschnitt (2) und der Plasmabehandlungszone (14) angeordnet ist.

13. Vorrichtung nach einem der Ansprüche 11 bis 12, **dadurch gekennzeichnet, dass** sie Plasmavorbehandlungsreaktoren (4', 4") stromauf vom Plasmahauptreaktor aufweist, die es gestatten, den Strom des Behandlungsgases und die durch ein Trägergas mitgeführten Kerne getrennt zu aktivieren.

14. Vorrichtung nach dem vorangehenden Anspruch, **dadurch gekennzeichnet, dass** jeder Plasmavorbehandlungsreaktor stromauf von seiner Plasmabehandlungszone (14', 14") mit einem der hydrodynamischen Filter ausgerüstet ist.

15. Vorrichtung nach einem der Ansprüche 11 bis 14, **dadurch gekennzeichnet, dass** sie eine oder mehrere externe Quellen akustischer Schwingungen umfasst.

16. Vorrichtung nach einem der Ansprüche 11 bis 15, **dadurch gekennzeichnet, dass** die Plasmaerzeugungsvorrichtung Mittel zur Plasmaerzeugung durch Impulse umfasst.

17. Vorrichtung nach einem der Ansprüche 11 bis 16, **dadurch gekennzeichnet, dass** sie seitliche Eingänge (12) zum Einblasen eines neutralen Gases entlang der Innenseite der Wandung des oder der Plasmareaktoren (4, 4', 4") umfasst.

18. Vorrichtung nach einem der Ansprüche 11 bis 17, **dadurch gekennzeichnet, dass** sie einen Sammelabschnitt (8) am Ausgang der Vorrichtung umfasst, der einen peripheren Kanal für den Abzug der Gase und der Kerne umfasst, die in der Grenzschicht entlang der Innenseite des Reaktors fliessen.

19. Vorrichtung nach einem der Ansprüche 11 bis 18, **dadurch gekennzeichnet, dass** das hydrodynamische Filter eine Mehrzahl kleiner Längskanäle umfasst, die in der Richtung der Strömung durch den Reaktor verlaufen, dem es vorgeschaltet ist.

20. Vorrichtung nach einem der Ansprüche 11 bis 19, **dadurch gekennzeichnet, dass** die Plasmaerzeugungsvorrichtung Elektroden (23, 25) umfasst, die zu beiden Seiten der Plasmabehandlungszone (14) angeordnet sind, wobei die eine der Elektroden Metallnadeln (27) umfasst, die auf der Elektrodenoberfläche verteilt und zur anderen Elektrode hin gerichtet sind, während die HF-Stromquelle eine Impulsquelle ist.

21. Vorrichtung nach dem vorangehenden Anspruch, **dadurch gekennzeichnet, dass** der Plasmareaktor die Gestalt eines Parallelepipeds besitzt, wobei die Elektroden auf den einander gegenüberliegenden, zur Richtung der Gasströmung parallelen Seiten angeordnet sind.

22. Vorrichtung nach Anspruch 20, **dadurch gekennzeichnet, dass** der Plasmareaktor zylindrisch und aus zwei koaxialen Elektroden zusammengesetzt ist, wobei ihre Achsen parallel zur Richtung der Gasströmung sind.

23. Vorrichtung nach dem vorangehenden Anspruch, **dadurch gekennzeichnet, dass** die zentrale Elektrode mit der HF-Impulsstromquelle verbunden ist und die Metallnadeln umfasst, während die Aussenelektrode geerdet ist.

24. Vorrichtung nach Anspruch 19, **dadurch gekennzeichnet, dass** die Länge der Längskanäle in der Mitte des Filters grösser als mit zunehmender Entfernung von der Mitte ist.

25. Vorrichtung nach Anspruch 19 oder 24, **dadurch gekennzeichnet, dass** die Kanäle aus dünnen Wänden einer Struktur im Wesentlichen in Bienenwabengestalt gebildet werden.

**Claims**

1. A method for producing a powder made of composite grains having a core and one or several surface layers, comprises the steps of : mixing grain cores with a plasmochemical treatment gas, passing through a main plasma reactor a flow of the mixture of the cores and of the treatment gas, and generating a uniform plasma substantially at atmospheric pressure, in a treatment region of the main reactor, in order to produce a plasmochemical reaction between the treatment gas and the surfaces of the cores, so as to form surface layers thereupon, as said mixture flows through the reactor.

2. A method for producing a powder according to claim 1, **characterised in that** the surface of the cores is activated beforehand, upstream of the plasma treatment region of the main reactor.

3. A method for producing a powder according to claim 1 or 2, **characterised in that** the excitation energy of the atoms or of the molecules of the treatment gas generating the layer deposited on the cores is between 0.02 eV per atom or molecule and the thermal decomposition energy of the core.

4. A method according to one of the preceding claims, **characterised in that** the plasma is generated by pulses, of which the leading edge, the duration and the frequency are such that shock waves are generated which produce acoustic vibrations.

5. A method according to one of the preceding claims, **characterised in that** acoustic vibrations are generated in the plasma by means of an external acoustic generator.

6. A method according to one of the preceding claims, **characterised in that** the treatment gases and the carrier gas containing the cores are mixed homogenously together upstream of the plasma treatment region.

7. A method according to the preceding claim, **characterised in that** the flow of the gaseous mixture is made uniform before its excitation by the plasma, by means of a hydrodynamic filter.

8. A method according to one of the preceding claims, **characterised in that** a neutral gas is injected along the walls of the plasma reactor or reactors, to form the gas boundary layer on the inner surface of said walls.

9. A method according to one of the preceding claims, **characterised in that** the flow of treatment gas and the flow of the carrier gas carrying the cores are excited separately and contacted with each other after having been excited, the time elapsed between the excitation and their contacting each other being shorter than the relaxation time of the excited components of the gas and of the cores.

10. A method according to one of the preceding claims, **characterised in that** the flow rate of the treatment gas is selected in such a manner as to achieve saturation of the deposition process of the surface layer on the cores, the thickness of the deposited layer being controlled by the residence time of the cores in the plasma treatment region with the treatment gases.

11. A device for carrying out a method for producing a powder comprised of composite grains having a core and one or several surface layers according to one of claims 1 to 10, including a main plasma reactor (4, 10, 204, 304) operating at atmospheric pressure, the reactor including a plasma generating device (15) and a chamber (14) defining a plasma treatment region through which flows a mixture of a plasmochemical treatment gas and of cores, and a mixing part (2, 2') upstream of the treatment region, for mixing together the treatment gas and the cores carried by a carrier gas, **characterised in that** it comprises at least one hydrodynamic filter (6, 6', 6") upstream of the plasma treatment region, for uniformising the velocity of the gas or of the mixture of gas and cores travelling through the hydrodynamic filter.

12. A device according to the preceding claim, **characterised in that** the hydrodynamic filter is provided between the mixing part (2) and the plasma treatment region (14).

13. A device according to one of claims 11 to 12, **characterised in that** it includes plasma pre-treatment reactors (4', 4") upstream of the main plasma reactor, which make it possible to activate separately the flow of treatment gas and of the cores carried by a carrier gas.

14. A device according to the preceding claim, **characterised in that** each plasma pre-treatment reactor is provided with one of said hydrodynamic filters upstream of the corresponding plasma treatment region (14', 14").

15. A device according to one of claims 11 to 14, **characterised in that** it comprises one or several external sources of acoustic vibrations.

16. A device according to one of claims 11 to 15, **characterised in that** the plasma generating device comprises means for generating the plasma by pulses.

17. A device according to one of claims 11 to 16, **characterised in that** it comprises lateral inlets (12) for injecting a neutral gas along the inner surface of the wall of the plasma reactor or reactors (4, 4', 4").

18. A device according to one of claims 11 to 17, **characterised in that** it includes a collector part (8) at the outlet of the device, comprising a peripheral channel for evacuating the gases and the cores travelling in the boundary layer along the inner surface of the reactor.

19. A device according to one of claims 11 to 18, **characterised in that** the hydrodynamic filter comprises a plurality of small longitudinal channels aligned in the direction of the flow through the reactor it precedes.

20. A device according to one of claims 11 to 19, **characterised in that** the plasma generating device comprises electrodes (23, 25) arranged respectively on two opposite sides of the plasma treatment region (14), wherein one of the electrodes carries metal needles (27) distributed over the surface of the electrode while being directed towards the other electrode and wherein the HF current source is a pulsed source.

21. A device according to the preceding claim, **characterised in that** the plasma reactor is parallelepipedal and **in that** the electrodes are arranged on opposite faces running parallel to the direction of the flow of gas.

22. A device according to claim 20, **characterised in that** the plasma reactor is cylindrical and is comprised of two coaxial electrodes having their axes running parallel to the direction of the flow of gas.

23. A device according to the preceding claim, **characterised in that** the central electrode is connected to the pulsed HF current source and **in that** it includes metal needles, while the peripheral electrode is grounded.

24. Device according to claim 19, **characterised in that** the length of the longitudinal channels is greater at the centre of the filter than when moving away from the centre.

25. Device according to claim 19 or 24, **characterised in that** the channels are defined by the thin walls of a structure substantially in the form of a honeycomb.

FIG.1b

FIG. 1a

FIG. 1

FIG. 2

**FIG. 3**